# EUROPEAN PATENT APPLICATION

(11) **EP 4 518 598 A1**
(43) Date of publication of application: **05.03.2025**
(21) Application number: 23193988.5
(22) Date of filing: 29.08.2023
(51) Int. Cl.: H05K 7/20, H05K 5/00

(54) **ELECTRONIC DEVICE FOR A VEHICLE COMPRISING A THERMAL INSULATION PAD**

(71) Applicant: Valeo Comfort and Driving Assistance, 94000 Créteil (FR)
(72) Inventor: RANA, Gyana-Ranjan, 94000 Créteil (FR)
(74) Representative: Delplanque, Arnaud

(57) **Abstract**

The invention relates to an electronic device (1) for a vehicle (2), said electronic device comprising:
- a housing (10),
- a cover (11) that is configured to close said housing (10),
- at least one electronic component (12),
- an electronic support (13) that is configured to support said at least one electronic component (12),
- a heatsink (14) that is configured to cool said at least one electronic component (12),
wherein said electronic device (1) further comprises at least one thermal insulation pad (15) that is configured to prevent heat generated by said at least one electronic component (12) to flow back from said heatsink (14) to said electronic support (13).

## Description

### FIELD OF THE INVENTION

The present invention relates to an electronic device for a vehicle. Such electronic device, may be used, but not exclusively, in the automotive domain and in particular for telematics control.

### BACKGROUND OF THE INVENTION

In the automotive domain, an electronic device for a vehicle that is used for telematics control, well-known by the person skilled in the art, comprises:
- a housing,
- a cover that is configured to close said housing,
- at least one electronic component,
- an electronic support that is configured to support said electronic component and that is disposed within the housing,
- a heatsink that is configured to cool said electronic component and that is disposed within the housing.

In the telematics control application, the at least one electronic component is a TCU sensor chip. The heatsink has two legs on which the electronic support is disposed on. Therefore, it is in contact with the electronic support. The heatsink is placed below the electronic support and has a base that extends along the whole surface of the electronic support. It has about the same size than the electronic support.

The housing is configured to receive the TCU sensor chip, the electronic support and the heatsink. These three elements are placed inside the housing.

One problem of this prior art is that during the operation of cooling, after some period of time the heatsink will heat back the TCU sensor chip and other electronic components on the electronic support as the heat generated by said TCU sensor chip and other electronic components flows back from the heatsink to the electronic support through the two points of contact that are formed by the legs of the heatsink. Thus, the temperature of the TCU sensor chip and the electronic support will further increase after some time despite the cooling.

It is an object of the invention to provide an electronic device for a vehicle, which resolves the problem above-stated.

### SUMMARY OF THE INVENTION

To this end, it is provided an electronic device for a vehicle , said electronic device comprising :
- a housing,
- a cover that is configured to close said housing,
- at least one electronic component,
- an electronic support that is configured to support said at least one electronic component,
- a heatsink that is configured to cool said at least one electronic component,
wherein said electronic device further comprises at least one thermal insulation pad that is configured to prevent heat generated by said at least one electronic component to flow back from said heatsink to said electronic support.

As we will see in further details, the thermal insulation pad permits to cut off the thermal bridge between the heatsink and the electronic support and in particular the TCU sensor chip so that no heat flows back to said TCU sensor chip and said electronic support.

According to non-limitative embodiments of the invention, the electronic device for a vehicle further comprises the following characteristics.

In a non-limitative embodiment, said at least one thermal insulation pad (16) is disposed between said heatsink (14) and said housing.

In a non-limitative embodiment, said heatsink is isolated from said electronic support or is in direct contact with said electronic support.

In a non-limitative embodiment, said at least one thermal insulation pad is disposed between said electronic support and said heatsink.

In a non-limitative embodiment, said heatsink is about the same width as said electronic support.

In a non-limitative embodiment, said electronic device further comprises a thermo-electric cooler disposed between said heatsink and said electronic support.

In a non-limitative embodiment, said heatsink is about the same width as said thermo-electric cooler.

In a non-limitative embodiment, said thermo-electric cooler has a width that is larger than the width of the thermo-electric cooler.

In a non-limitative embodiment, said electronic device further comprises two thermal interface materials that are respectively placed between said electronic support and said thermo-electric cooler, and between said thermo-electric cooler and said heatsink.

In a non-limitative embodiment, said heatsink comprises fins that extend from a base and pass through said housing.

In a non-limitative embodiment, said housing is of a metal material or of a thermoplastic material.

In a non-limitative embodiment, said at least one electronic component is a TCU sensor chip.

In a non-limitative embodiment, said electronic device is a telematics control unit.

In a non-limitative embodiment, only one thermal insulation pad is disposed between said heatsink and said housing.

In a non-limitative embodiment, two thermal insulation pads are disposed between said electronic support and said heatsink.

In a non-limitative embodiment, said housing is composed of an upper housing and a lower housing.

In a non-limitative embodiment, said heatsink is composed of a base and of two legs.

In a non-limitative embodiment, said thermal insulation pad is disposed between the base of said heatsink and the base of said lower housing.

In a non-limitative embodiment, the electronic support has a top side and low side opposed to the top side.

In a non-limitative embodiment, the legs of the heatsink are in contact with the low side of the electronic support.

In a non-limitative embodiment, two thermal insulation pads are disposed each between one of the two legs of said heatsink and the low side of said electronic support.

In a non-limitative embodiment, the thermo-electric cooler is disposed between the base of said heatsink and the low side of said electronic support.

In a non-limitative embodiment, the thermo-electric cooler is placed on the side of the electronic support opposed to the side where the at least one electronic component is placed and in regard to said TCU sensor chip.

In a non-limitative embodiment, the thermos-electric cooler has a size slightly bigger than at least one electronic component.

In a non-limitative embodiment, the fins of said heatsink pass through the lower housing.

In a non-limitative embodiment, the electronic device comprises a plurality of electronic components.

### BRIEF DESCRIPTION OF THE DRAWINGS

Some embodiments of methods and/or system in accordance with embodiments of the present invention are now described, by way of example only, and with reference to the accompanying drawings, in which:

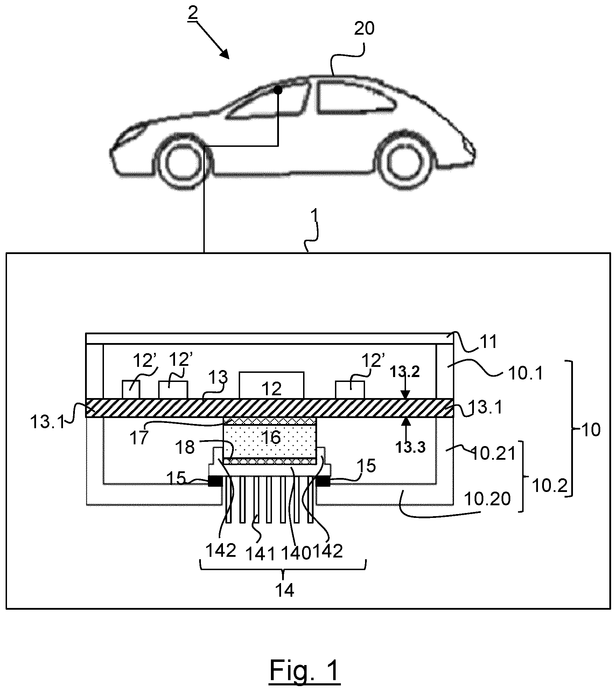

Figure 1 is a schematic diagram of an electronic device for a vehicle according to a first non-limitative variant of a first non-limitative embodiment of the invention, said electronic device comprising a housing, a cover, at least one electronic component, an electronic support, and at least one thermal insulating pad,

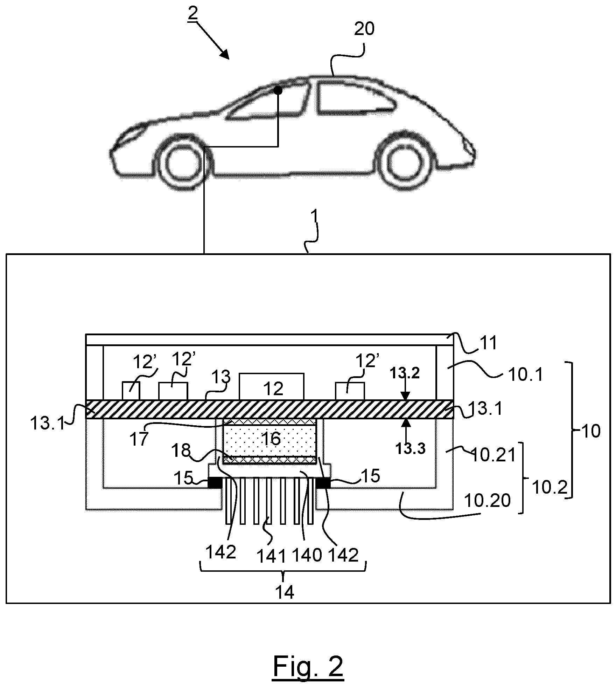

Figure 2 is a schematic diagram of an electronic device for a vehicle according to a second non-limitative variant of a first non-limitative embodiment of the invention, said electronic device comprising a housing, a cover, at least one electronic component, an electronic support, and at least one thermal insulating pad,

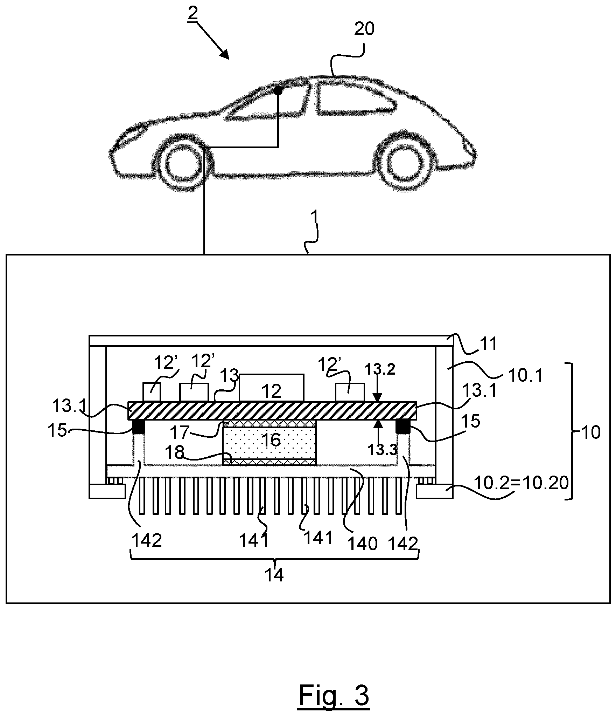

Figure 3 is a schematic diagram of an electronic device for a vehicle according to a second non-limitative embodiment of the invention, said electronic device comprising a housing, a cover, at least one electronic component, an electronic support, and at least one thermal insulating pad.

### DESCRIPTION OF EMBODIMENTS OF THE INVENTION

In the following description, well-known functions or constructions by the person skilled in the art are not described in detail since they would obscure the invention in unnecessary detail.

The present invention relates to an electronic device 1 for a vehicle 2, said electronic device 1 being described in reference to figures 1 to 3. In a non-limitative embodiment, the vehicle 2 is a motor vehicle. In non-limitative variants of embodiment, the motor vehicle 2 has a combustion engine, has an electric engine, or an hybrid engine.

In a non-limitative embodiment, the electronic device 1 is a telematics control unit also referred to as TCU in the following. In a non-limitative embodiment, the TCU is mounted on the roof 20 of the vehicle 2 inside the vehicle 2. This non-limitative embodiment is taken as a non-limitative example in the following.

As illustrated in figures 1 to 3, the electronic device 2 comprises :
- a housing 10,
- a cover 11,
- at least one electronic component 12,
- an electronic support 13,
- a heatsink 14,
- at least one heat insulation pad 15.

These different elements are described in detail hereinafter.

The housing 10 is configured to receive said at least one component 12, the electronic support 14, the heatsink 14, and said at least one heat insulation pad 15.

In non-limitative embodiments, the housing 10 is of a metal material or of a thermoplastic material. The thermoplastic material is lighter than the metal material and the cost is reduced.

In a non-limitative embodiment, the housing 10 is composed of two parts, an upper housing 10.1 and a lower housing 10.2.

In a first non-limitative embodiment illustrated in figures 1 and 2, the lower housing 10.2 is composed of a base 10.20 and a wall 10.21 that extends perpendicular to the base 10.20. The upper housing 10.1 extends along the wall 10.21 of the lower housing 10.2 when the electronic device 1 is assembled.

In a second non-limitative embodiment illustrated in figure 3, the lower housing 10.2 is only composed of a base. The upper housing 10.1 extends perpendicular to the lower housing 10.2 and is based on the lower housing 10.2 when the electronic device 1 is assembled.

In a first non-limitative embodiment illustrated in figures 1 and 2, the upper housing 10.1 and the lower housing 10.2 are configured to hold the electronic support 13. In particular, they hold it along its border 13.1. In this case, the lower housing 10.2 is composed of the base 10.20 and a wall 10.21.

Its wall 10.21 and the upper housing 10.2 held the electronic support 13.

The cover 11 is configured to close the housing 10.1. It is configured to be placed on the upper housing 10.1.

The cover 11 is in contact with the roof 20 of the vehicle 2, in particular with a decorative part, where it can be fixed. In a non-limitative example, it is fixed with screws (not illustrated).

Hence, in a non-limitative example, the TCU is placed above the head of the passengers of the vehicle 2.

In a non-limitative embodiment, said at least one component 12 is a TCU sensor chip 12.

In a non-limitative embodiment, the TCU comprises only one TCU sensor chip 12. This non-limitative embodiment is taken as a non-limitative example in the following.

The TCU sensor chip 12 is configured to receive and emit some signals (not illustrated) for the vehicle to communicate with other vehicles, with a base station or other telecommunication equipment. In non-limitative embodiments, these signals are used for semi-autonomous or autonomous driving. As, such a TCU sensor chip 12 is well-known by the person skilled in the art, it is not described here.

The TCU sensor chip 12 generates some heat that has to be managed. It produces higher power than other electronic components inside the TCU. So it generates more heat. The TCU sensor chip 12 is placed on the electronic support 13, on a side 13.2 of said electronic support 13 that is opposed to the one 13.3 where the heatsink 14 is.

The upper housing 10.1 with the cover 11 covers the TCU sensor chip 12.

The electronic support 13 is configured to support the TCU sensor chip 12. It also supports other electronic components 12' such as in non-limitative examples wifi chip, inductor, ethernet chip, audio power amplifier, power supplier.

In a non-limitative embodiment, the electronic support 13 is a printed circuit board assembly also referred to as PCBA in the following. The electronic support 13 has a border 13.1 that extends along all the perimeter of the electronic support 13. It has a top side 13.2 and a low side 13.3. The top side 13.2 is configured to receive the TCU sensor chip 12 and the other electronic components 12'.

The electronic support 13 is parallel to the base 10.20 of the lower housing 10.2 when the electronic device 1 is assembled.

In a first non-limitative embodiment illustrated in figures 1 and 2, the electronic support 13 is held by the upper housing 10.1 and the lower housing 10.2 along its border 13.1. It is sandwiched between the upper housing 10.1 and the lower housing 10.2. With this first non-limitative embodiment, one can have a smaller size heatsink 14 and thus one can reduce the cost and the weight of the electronic device 1.

In a second non-limitative embodiment illustrated in figure 3, the electronic support 13 is held by the heatsink 14. In particular, its border 13.1 is placed above two legs 142 of the heatsink 14.

The heatsink 14 is configured to cool the TCU sensor chip 12 and the electronic support 13 and the other electronic components 12' on the electronic support 13. To this end, the heatsink 14 comprises fins 141 that extend from a base 140, and legs 142 that extend from the base 140 and are perpendicular to the base 140. In a non-limitative embodiment, the fins 141 are perpendicular to the base 140. The fins 141 are also called cooling fins 141.

The heat coming from the TCU sensor chip 12 flows along the fins 141 of the heatsink 14 and is extracted via the fins 14 outside the housing 10.

In a non-limitative embodiment, the fins 141 pass through the housing 10, in particular the lower housing 10.2. It permits to take the heat generated by the TCU sensor chip 12 and the other electronic components 12' of the electronic support 13 and to output it from the housing 10. The heat is not held within the housing 10.

The heatsink 14 is disposed on the low side 13.3 of the electronic support 13 that is opposed to the one 13.2 where the TCU sensor chip 12 is. It is disposed in regard to the TCU sensor chip 12 so that it can efficiently collect the heat coming from the TCU sensor chip 12.

The at least one thermal insulation pad 15 is configured to prevent the heat generated in particular by the TCU sensor chip 12 to flow back from the heatsink 14 to the electronic support 13 and therefore it prevents the heating up of the electronic support 13, the TCU sensor chip 12 and the other electronic components 12'. In non-limitative embodiment, the thermal insulation pad 15 is of polymer material, or of plastic material, or of polyutherane material, or of fiber glass reinforced material. The material of the thermal insulation pad 15 is chosen in such a way that it is not thermally conductive to avoid heat flow. In a non-limitative embodiment, the material has a thermal conductivity inferior to 0.1W/m.K (Watt per meter Kelvin). A thermal conductivity closed to zero will not allow heat to transfer from the heatsink 14 to the electronic support 13.

In a first non-limitative embodiment, the electronic device 1 comprises one thermal insulation pad 15. In a second non-limitative embodiment, the electronic device 1 comprises two thermal insulation pad 15.

In a first non-limitative embodiment illustrated in figures 1 and 2, the thermal insulation pad 15 is disposed between the heatsink 14 and the housing 10. There is only one thermal insulation pad 15. In particular, it is disposed between the base 140 of the heatsink and the base 10.20 of the lower housing 10.2.

In a first non-limitative embodiment, the thermal insulation pad 15 is placed on the base 10.20 of the lower housing 10.2. In a non-limitative variant of embodiment, it is glued to the base 10.20. In another non-limitative variant of embodiment, it is fixed with two screws to the base 10.20.

In a second non-limitative embodiment, the lower housing 10.2 comprises a groove (not illustrated) where the thermal insulation pad 15 can be put inside. In particular the base 10.20 of the lower housing 10.2 comprises the groove.

On top view (not illustrated), in non-limitative embodiments, the thermal insulation pad 15 presents a circular, a rectangular, or a square form.

With the thermal insulation pad 15, the heat that comes from the TCU sensor chip 12 and that flows along the fins 141 of the heatsink 14 and that is extracted via the fins 14 outside the housing 10 can't flow back to the electronic support 14 via the lower housing 10.2, through the base 10.20 and then through the wall 10.21, as there is no more any direct contact between the lower housing 10.20 and the heatsink 14 thanks to the thermal insulation pad 15. The heat will not go to the electronic support 14 and it won't heat up the TCU sensor chip 12 and the other electronic components 12'.

In a first non-limitative variant of embodiment illustrated in figure 1, the heatsink 14 is isolated from the electronic support 13. It means that it has no direct contact with the electronic support 13. This arrangement allows cooling the TCU sensor chip 12 with the help of the thermo-electric cooler 16 described later in the following. Thus, the heat coming from the TCU sensor chip 12 will not heat the other electronic components 12'. Thus, their temperature will not be too high. Hence, it allows better thermal efficiency of the electronic components' temperature.

In a second non-limitative variant of embodiment illustrated in figure 2, the heatsink 14 is in direct contact with the electronic support 13. As illustrated, in particular the legs 142 of the heatsink 14 are in contact with the lower side 13.3 of the electronic support 13. It still allows a good efficiency when a lower consumption TCU sensor chip 12 is used.

In a second non-limitative embodiment illustrated in figure 3, the thermal insulation pad 15 is disposed between the electronic support 13 and the heatsink 14. Hence, the heatsink 14 is isolated from the electronic support 13. In particular, two thermal insulation pads 15 are disposed each between one of the two legs 142 of the heatsink 14 and the low side 13.3 of the electronic support 13. As we can see, the thermal insulation pads 15 are disposed at the level of the border 13.1 of the electronic support 13. In this case, in a first non-limitative embodiment, the thermal insulation pads 15 are glued to the electronic support 13 and to the heatsink 14. In a second non-limitative embodiment (not illustrated), the legs 142 comprise each one a groove where a thermal insulation pad 15 can be put inside.

As the heatsink 14 is not in contact with the electronic support 13, i.e. it is isolated from the electronic support 13, the heat that is coming from the TCU sensor chip 12 and that flows along the fins 141 of the heatsink 14 and that is extracted via the fins 14 outside the housing 10 can't flow back to the electronic support 14 via the heatsink 14, and in particular via the legs 142.

In a non-limitative embodiment illustrated in figure 3, the heatsink 14 has about the same width as the width of electronic support 13. It is to be noted that its length can be chosen according to the total power dissipation of the electronic components 12 and 12'. It permits to support the electronic support 13 on the legs 142 of the heatsink 14 along its border 13.1.

In a non-limitative embodiment illustrated in figures 1 to 3, the electronic device 1 further comprises a thermo-electric cooler 16 disposed between the heatsink 14 and the electronic support 13. The thermo-electric cooler 16 is also referred to as TEC in the following. In particular, the thermo-electric cooler 16 is disposed between the base 140 of the heatsink 14 and the low side 13.3 of the electronic support 13. The thermo-electric cooler 16 is placed on the heatsink 14, in particular on its base 140.

In a non-limitative embodiment, the thermo-electric cooler 16 is placed on the side (here the low side 13.3) of the electronic support 14 opposed to the side (here the top side 13.2) where the TCU sensor chip 12 is placed and in regard to said TCU sensor chip 12. In a non-limitative embodiment, the thermos-electric cooler 16 has a size slightly bigger than the TCU sensor chip 12.

As it is placed opposite to the TCU sensor chip 12 and its size is slightly bigger, the thermo-electric cooler 16 permits to enhance the extraction of the heat from the TCU sensor chip 12 and the other electronic components 12'. The thermo-electric cooler 16 transfers the heat in particular from the power source which is the TCU sensor chip 12 to the heatsink 14. It is to be noted that a TEC requires external current to be operational whereas the heatsink 14 doesn't need any current. Cooling the TCU sensor chip 12 and the electronic components 12' using the TEC in combination with the heatsink 14 is more efficient compared to the cooling with only the heatsink 14. The TEC, with consumption of electrical energy, brings heat from the TCU sensor 12 and the other electronic components 12' and transfers it to the heatsink 14.

In a first non-limitative embodiment illustrated in figure 1 and 2, the heatsink 14 is about the same width as the thermo-electric cooler 16. The size of the heatsink 14 is reduced and thus its cost.

In a second non-limitative embodiment illustrated in figure 3, the heatsink 14 has a larger width than the width of the thermo-electric cooler 16 as said heatsink 14 has about the same width as the width of the electronic support 13.

In a non-limitative embodiment, the electronic device 1 further comprises two thermal interface materials 17, 18. A first thermal interface material 17 is placed between the electronic support 13 and the thermo-electric cooler 16. A second thermal interface material 18 is placed between the thermo-electric cooler 16 and the heatsink 14. A thermal interface material is also referred to as TIM in the following. The thermal interface materials 17, 18 permits to fill in the air gap between the electronic support 14 and the thermos-electric cooler 16, and the air gap between the thermo-electric cooler 16 and the heatsink 14 so that the heat flows with low thermal resistance. The heat will flow easily. Thanks to the TIMs, the thermal resistance between one element and another one is reduced (between the electronic support 13 and the thermo-electric cooler 16, and between the thermo-electric cooler 16 and the heatsink 14). It means that there is less temperature difference between one element to another one. Therefore, the use of the thermal interface materials 17, 18 eases the transmission of the heat from the electronic support 13 to the thermo-electric cooler 16, and from the thermo-electric cooler 16 to the heatsink 14. It is to be noted that the TIMs also avoid short-circuit between the electronic support 13 and the thermo-electric cooler 16 as they are not in direct contact altogether.

It is to be noted that as the fins 141 of the heatsink 14 pass through the lower housing 10.2, the heat can flow outside the housing 10. Therefore, there is no need to have a thermo-electric cooler 16 with high capacity that needs a high current consumption to help the heatsink 14 to cool the TCU sensor chip 12 and the electronic support 13 with the other electronic components 12'.

It is to be understood that the present invention is not limited to the aforementioned embodiments and variations and modifications may be made without departing from the scope of the invention. All statements herein reciting principles, aspects, and embodiments of the invention, as well as specific examples thereof, are intended to encompass equivalents thereof. In this respect, the following remarks are made. Hence, in another non-limitative application, the electronic device 1 is an electronic device used for computers or any other applications different from the automotive application.

Hence, some embodiments of the invention may comprise one or a plurality of the following advantages:
- it permits to avoid a flowing back of the heat to the TCU sensor chip 12 and to the electronic support 13 with the other electronic components 12', and thus it avoids heating up the TCU sensor chip 12 and the electronic support 13 with the other components 12',
- the electronic device 1 is thermally safer than the solution of the prior art, and for longer duration,
- thanks to the fins 141 that passes through the housing 10, the heat can go out from the housing even if the space is limited within the housing 10, contrary to the prior art where the heat can't go out the housing and the heat stays inside the housing 10.

## Claims

1. Electronic device (1) for a vehicle (2), said electronic device comprising :
- a housing (10),
- a cover (11) that is configured to close said housing (10),
- at least one electronic component (12),
- an electronic support (13) that is configured to support said at least one electronic component (12),
- a heatsink (14) that is configured to cool said at least one electronic component (12),
wherein said electronic device (1) further comprises at least one thermal insulation pad (15) that is configured to prevent heat generated by said at least one electronic component (12) to flow back from said heatsink (14) to said electronic support (13).

2. Electronic device (1) according to claim 1, wherein said at least one thermal insulation pad (16) is disposed between said heatsink (14) and said housing (10.2).

3. Electronic device (1) according to the preceding claim, wherein said heatsink (14) is isolated from said electronic support (13) or is in direct contact with said electronic support (13).

4. Electronic device (1) according to claim 1, wherein said at least one thermal insulation pad (16) is disposed between said electronic support (13) and said heatsink (14).

5. Electronic device (1) according to any of the preceding claim, wherein said heatsink (14) is about the same width as said electronic support (13).

6. Electronic device (1) according to any of the preceding claims, wherein said electronic device (1) further comprises a thermo-electric cooler (16) disposed between said heatsink (14) and said electronic support (13).

7. Electronic device (1) according to any of the preceding claims 2 or 3 combined with claim 6, wherein said heatsink (14) is about the same width as said thermo-electric cooler (16).

8. Electronic device (1) according to any of the preceding claims 4 or 5 combined with claim 6, wherein said thermo-electric cooler (16) has a width that is larger than the width of the thermo-electric cooler (16).

9. Electronic device (1) according to any of the preceding claims 6 to 8, wherein said electronic device (1) further comprises two thermal interface materials (17, 18) that are respectively placed between said electronic support (13) and said thermo-electric cooler (17), and between said thermo-electric cooler (16) and said heatsink (14).

10. Electronic device (1) according to any of the preceding claims, wherein said heatsink (14) comprises fins (141) that extend from a base (140) and pass through said housing (10).

11. Electronic device (1) according to any of the preceding claims, wherein said housing (10) is of a metal material or of a thermoplastic material.

12. Electronic device (1) according to any of the preceding claims, wherein said at least one electronic component (12) is a TCU sensor chip.

13. Electronic device (1) according to any of the preceding claims, wherein said electronic device is a telematics control unit.
